# EUROPÄISCHE PATENTSCHRIFT

(11) **EP 1 894 240 B1**
(45) Veröffentlichungstag und Bekanntmachung des Hinweises auf die Patenterteilung: **15.04.2009**
(21) Anmeldenummer: 05767544.9
(22) Anmeldetag: 23.06.2005
(51) Int. Cl.: H01L 23/62

(54) **Elektronikmodul**
Electronic module
Module électronique

(43) Veröffentlichungstag der Anmeldung: 05.03.2008
(73) Patentinhaber: SIEMENS AKTIENGESELLSCHAFT, 80333 München (DE)
(72) Erfinder: DORN, Jörg, 96155 Buttenheim (DE)
(86) Internationale Anmeldenummer: PCT/DE2005/001147
(87) Internationale Veröffentlichungsnummer: WO 2006/136123

(56) Entgegenhaltungen:
- DE-A1- 10 103 031
- US-A- 5 734 197
- US-A1- 2003 187 630

## Beschreibung

Die Erfindung betrifft ein Elektronikmodul mit mindestens einer ersten und einer zweiten Anschlussklemme sowie mit über Verbindungsleiter verbundenen Leistungshalbleitern, den Leistungshalbleitern jeweils parallel geschalteten Dioden und wenigstens einem ebenfalls über Verbindungsleiter mit den Leistungshalbleitern verbundenen Kondensator.

Aus der DE 101 03 031 A1 ist ein solches Elektronikmodul sowie eine Reihenschaltung solcher Elektronikmodule zum Ausbilden eines Umrichters bereits bekannt. Bei dem auf diese Weise ausgebildeten Umrichter kann der Ausfall eines Elektronikmoduls, beispielsweise aufgrund eines defekten Bauelements der Schaltungsanordnung, zum Abschalten des gesamten Umrichters führen. Dies ist insbesondere nachteilig, wenn der Umrichter in Energieübertragungs- bzw. - verteilungsanlagen verwendet wird und eine hohe Verfügbarkeit und eine große Betriebssicherheit aufweisen muss.

Aus der US 5,734 197 ist ein integrierter Schaltkreis bekannt, bei dem eine Zuleitung aus einer Bimetallzusammensetzung gebildet ist, die sich durch Erhitzen in Folge eines zu hohen Stromes verformt und eine Überbrückung des integrierten Schaltkreises zum Schutze desselben ausbildet.

Aufgabe der vorliegenden Erfindung ist es, ein Elektronikmodul der eingangs erwähnten Art auszubilden, mit dem in einem Fehlerfall eine hohe Verfügbarkeit und Betriebssicherheit des Umrichters gewährleistet werden kann.

Erfindungsgemäß gelöst wird diese Aufgabe dadurch, dass die Verbindungsleiter mindestens zwei parallel zueinander verlaufende Abschnitte aufweisen, von denen mindestens einer deformierbar ist, über die der im Elektronikmodul fließende Strom gegensinnig geführt ist, so dass aufgrund elektromagnetischer Wechselwirkung eine Kraft erzeugt wird, welche die Verbindungsleiter auseinanderdrückt, und die so dimensioniert sind, dass diese beim Überschreiten eines Schwellstromes eine leitende Verbindung zwischen den Anschlussklemmen ausbilden und die Leistungshalbleiter und jeden Kondensator überbrücken.

Eine solche Anordnung nutzt in vorteilhafter Weise einen in einem Fehlerfall auftretenden hohen Fehlerstrom, der in dem Elektronikmodul fließt. Durch die parallel zueinander verlaufenden Abschnitte, in denen der im Elektronikmodul fließende Strom gegensinnig geführt ist, wird aufgrund elektromagnetischer Wechselwirkung eine Kraft erzeugt, welche die Verbindungsleiter auseinanderdrückt. Die mechanische Festigkeit der deformierbaren Abschnitte ist so eingestellt, dass beim Überschreiten eines Schwellstromes diese Kraft ausreichend groß ist, um eine Deformation zu bewirken. Der Schwellstrom ist beispielsweise um ein Vielfaches größer als ein im Normalbetrieb im Elektronikmodul fließender Nennstrom. Aufgrund der hohen Kapazität des Kondensators und der niederinduktiven Eigenschaften der Verbindungsleiter ist ein Fehlerstrom, der beispielsweise bei einem defekten Leistungshalbleiter durch das Entladen des Kondensators auftritt, größer als der Schwellstrom, so dass der deformierbare Abschnitt durch die in diesem Fall wirkende Kraft deformiert wird. Der Begriff deformierbarer Abschnitt ist dabei keineswegs auf eine irreversible Verformung von Materialien begrenzt. Eine Deformation kann im Rahmen der Erfindung auch unter Einsatz von Gelenken oder dergleichen stattfinden, so dass im Fehlerfall keine irreversible Verformung erfolgt. Diese Deformation führt zu einer leitenden Verbindung zwischen den Anschlussklemmen des Elektronikmoduls, so dass das defekte Elektronikmodul überbrückt ist. In einer Reihenschaltung mehrerer Elektronikmodule, wie sie beispielsweise in einem Umrichter verwendet wird, ist durch die Überbrückung des defekten Elektronikmoduls ein Weiterbetrieb des Umrichters möglich, wenn Anzahl und Ansteuerung der verbleibenden Elektronikmodule des Umrichters entsprechend ausgelegt sind.

In einer bevorzugten Ausführungsform sind die deformierbaren Abschnitte durch Stromschienen realisiert, die mit der ersten Anschlussklemme unmittelbar verbunden sind, wobei die Stromschienen in der Nähe eines Kontaktteils angeordnet sind, welches mit der zweiten Anschlussklemme unmittelbar verbunden ist. Eine starre und somit deformierbare Stromschiene, welche durch die bei einem normalen Nennstrom wirkenden Kräfte nicht deformiert wird, sich dagegen durch die bei einem höheren Fehlerstrom wirkenden Kräfte verformt, wird durch die Verformung gegen ein Kontaktteil bewegt und bildet die leitende Verbindung der Anschlussklemmen zur Überbrückung des Elektronikmoduls im Fehlerfall aus.

In zweckmäßiger Ausgestaltung sind die Stromschienen als mäanderförmig gebogene Stromschiene realisiert. Bei einer solchen mäander- oder schleifenartigen Anordnung führt der in den Teilstücken in entgegen gesetzter Richtung fließende Strom zu einer Abstoßungskraft, die im Falle eines hohen Fehlerstromes zu einer ausreichenden Deformation der Stromschiene führt, so dass einer der Abschnitte eine leitende Verbindung zwischen den Anschlussklemmen des Elektronikmoduls ausbildet. Die deformierbare Stromschiene kann auch eine Anordnung mit beispielsweise vier Teilstücken, die parallel zueinander angeordnet sind, aufweisen, wobei jeweils zwei benachbarte Teilstücke an einem Ende miteinander verbunden sind. Der Einsatz mehrerer paralleler Teilstücke erhöht die Deformationswirkung durch die elektromagnetischen Kräfte.

In einer zweckmäßigen Weiterbildung weisen gebogene Bereiche der Stromschiene eine geringere Querschnittsfläche als die geradlinigen Bereiche auf. Bei einer Verbindung mit einer geringeren Querschnittsfläche ist eine Sollbruchstelle der deformierbaren Stromschiene ausgebildet, so dass bei den im Fehlerfall zwischen den Teilstücken auftretenden Kräften die deformierbare Stromschiene an der Sollbruchstelle auseinander bricht. Dadurch wird der parallel zu den Anschlussklemmen angeordnete Leistungshalbleiter vom Stromkreis getrennt. Dies ist besonders vorteilhaft, wenn ein weiteres Sicherungselement wie beispielsweise eine so genannte Scheibenzellendiode, die als solche bekannt ist, zwischen den Anschlussklemmen angeordnet ist. Durch eine von einer Steuerungseinheit herbeigeführte an der Scheibenzellendiode anliegende hohe Spannung wird diese zerstört und bildet einen zusätzlichen Strompfad für den Laststrom des Umrichters aus.

In weiterer Ausgestaltung der Erfindung sind Mittel zum Ausbilden einer kraftschlüssigen Verbindung eines der deformierbaren Abschnitte mit dem Kontaktteil vorgesehen. Eine solche kraftschlüssige Verbindung zwischen dem deformierbaren Abschnitt und dem Kontaktteil ist vorteilhaft, da zusätzlich zur elektrodynamischen Kraft eine mechanische Kraft aufgewendet wird, um die leitende Verbindung zwischen dem deformierbaren Abschnitt und der Anschlussklemme auszubilden. Dadurch wird der Kontakt verbessert und die Sicherheit der Überbrückung des defekten Elektronikmoduls erhöht.

In zweckmäßiger Weiterbildung umfassen die Mittel eine Schraubverbindung. Eine solche Schraubverbindung der beiden Abschnitte kann zu einer Vorspannung eines deformierbaren Abschnitts verwendet werden, wobei die im Fehlerfall auftretende Kraft zu einem Abreißen der Schraubverbindung führt. Dabei wird der durch die Schraubverbindung in Richtung des zweiten Abschnitts vorgespannte erste Abschnitt gelöst und bildet eine kraftschlüssige Verbindung mit der Anschlussklemme.

In einer anderen Ausgestaltung umfassen die Mittel ein Federelement. Vorteilhafterweise führt ein Federelement in einem Fehlerfall und der daraus resultierenden Kraft zu einem zusätzlichen Andrücken des deformierbaren Abschnitts an das Kontaktteil, so dass in vorteilhafter Weise der Kontakt bzw. die Verbindung zwischen dem deformierbaren Abschnitt und dem Kontaktteil verbessert wird.

In zweckmäßiger Fortbildung ist das Federelement zwischen den deformierbaren Abschnitten angeordnet. Durch eine solche Anordnung wird ein deformierbarer Abschnitt durch die vom Federelement auf den deformierbaren Abschnitt ausgeübte Kraft gegen das Kontaktteil gedrückt.

In einer anderen Ausführungsform kann das Federelement am Kontaktteil angeordnet sein. Die Anordnung des Federelements am Kontaktteil ist eine andere zweckmäßige Ausführung zur Verbesserung der leitenden Verbindung zwischen dem deformierbaren Abschnitt und dem Kontaktteil.

In einer zweckmäßigen Ausgestaltung der Erfindung sind Mittel zum Ausbilden einer formschlüssigen Verbindung der deformierbaren Stromschiene mit der Klemme vorgesehen. Mit einer formschlüssigen Verbindung können die Eigenschaften der leitenden Verbindung und damit die Sicherheit der Überbrückung eines defekten Elektronikmoduls ebenfalls verbessert werden. Eine solche formschlüssige Verbindung zwischen dem Kontaktteil und dem deformierbaren Abschnitt kann beispielsweise durch einen Einrastmechanismus ausgebildet werden, bei dem ein Formstück am deformierbaren Abschnitt durch die vom Kurzschlussstrom erzeugte Kraft gegen ein am Kontaktteil angeordnetes zweites Formteil gedrückt wird und darin einrastet.

Die Erfindung wird im Folgenden anhand von Ausführungsbeispielen mit Bezug auf Figuren der Zeichnung beschrieben.

Es zeigen:
- Figur 1: eine schematische Darstellung der Schaltungsanordnung eines Elektronikmoduls;
- Figur 2: eine schematische Querschnittsansicht eines erfindungsgemäßen Elektronikmoduls in einem ersten Zustand;
- Figur 3: eine schematische Querschnittsansicht des Elektronikmoduls aus Figur 2 in einem zweiten Zustand;
- Figuren 4a bis 4e: Ausführungsbeispiele einer deformierbaren Stromschiene;
- Figur 5: eine schematische Darstellung eines erfindungsgemäßen Elektronikmoduls in einer zweiten Ausführungsform;
- Figur 6: eine schematische Darstellung eines erfindungsgemäßen Elektronikmoduls in einer dritten Ausführungsform;
- Figur 7: eine schematische Darstellung eines erfindungsgemäßen Elektronikmoduls in einer vierten Ausführungsform;
- Figur 8: eine schematische Darstellung eines erfindungsgemäßen Elektronikmoduls in einer fünften Ausführungsform;
- Figur 9: eine schematische Darstellung eines erfindungsgemäßen Elektronikmoduls in einer sechsten Ausführungsform;
- Figur 10: eine Detailansicht der Figur 9.

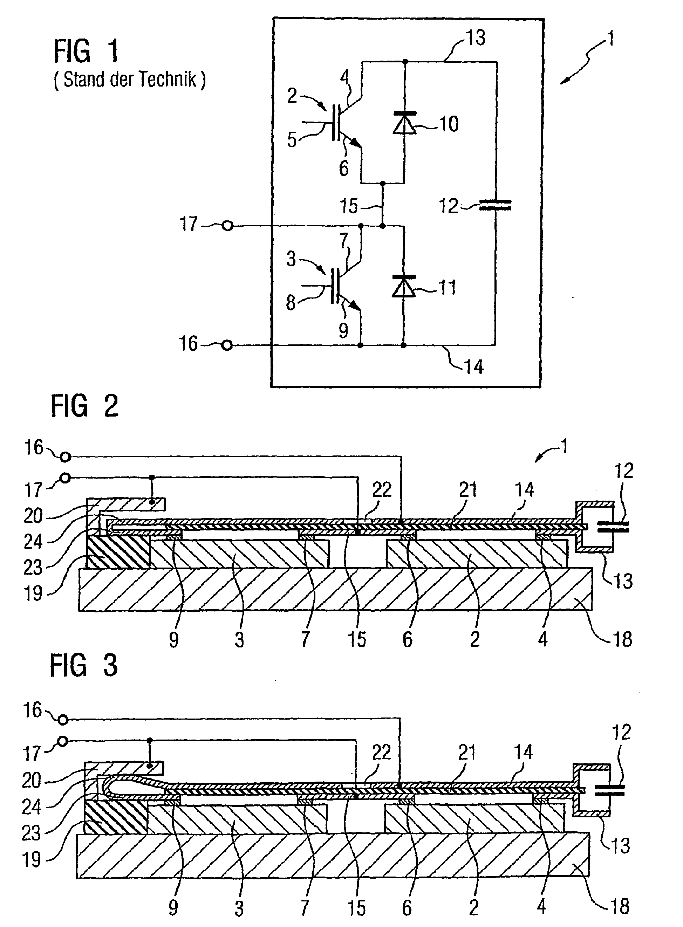

Figur 1 zeigt eine Schaltungsanordnung eines aus der DE 101 03 031 A1 bekannten Elektronikmoduls. Die Funktion des Elektronikmoduls 1 sowie die Anordnung mehrerer Elektronikmodule in einer Reihenschaltung bei einem Umrichter sind in der DE 101 03 031 A1 beschrieben, die hiermit vollständig Teil der vorliegenden Offenbarung ist. Das Elektronikmodul 1 umfasst zwei IGBT's 2,3 mit jeweiligen Emitteranschlüssen 4,7, Gateanschlüssen 5,8 und Kollektoranschlüssen 6,9. Den IGBT's 2,3 jeweils parallel geschaltet sind Freilaufdioden 10,11. Ein Kondensator 12 ist über Verbindungsleiter 13,14 mit den IGBT's und den Freilaufdioden verbunden. Ein weiterer Verbindungsleiter 15 verbindet die IGBT's 2,3 miteinander. Das Elektronikmodul 1 weist ferner Anschlussklemmen 16,17 auf.

Figur 2 zeigt eine schematische Querschnittsansicht eines Elektronikmoduls 1, bei dem vereinfachend die jeweiligen Gateanschlüsse 5,8 der IGBT's 2,3 sowie die parallel geschalteten Dioden 10,11 nicht dargestellt sind. Die IGBT's 2,3 sind auf einem Kühlkörper 18 befestigt. An einem Isolierkörper 19 ist ein Kontaktteil 20 angeordnet, welches mit der Anschlussklemme 17 leitend verbunden ist. Der Verbindungsleiter 14 ist durch eine isolierende Schicht 21 von den Verbindungsleitern 13 und 15 getrennt. Die Anschlussklemme 16 ist mit dem Verbindungsleiter 14 und die Anschlussklemme 17 mit dem Kontaktteil 20 sowie mit dem Verbindungsleiter 15 leitend verbunden. Die Anschlussklemme 17 ist mittels einer im Verbindungsleiter 14 angeordneten Aussparung 22, die gegen den Verbindungsleiter 14 isoliert ist, mit dem Verbindungsleiter 15 verbunden. Im Bereich des Kontaktteils 20 weist der Verbindungsleiter 14 eine in der gezeigten Seitenansicht U-förmige Schleife mit zwei parallel zueinander angeordneten deformierbaren Abschnitten 23 und 24 auf. Mit anderen Worten erstreckt sich der Verbindungsleiter 14 in der Nähe des Kontaktteils 20 mäanderförmig. Die im Normalbetrieb des Elektronikmoduls in den Verbindungsleitern 14 auf der einen und 13 und 15 auf der anderen Seite gegensinnig fließenden Ströme erzeugen elektrodynamische Kräfte, die durch die mit den Verbindungsleitern verklebte Isolierung 21 aufgenommen werden und die nicht ausreichen, um die Abschnitte 23 und 24 auseinander zu bewegen. Ist jedoch ein Bauteil des Elektronikmoduls defekt, so kann sich der Kondensator 12 entladen, wobei aufgrund der großen Kapazität des Kondensators 12 sowie der niederinduktiven Eigenschaften der Verbindungsleiter 13,14,15 ein sehr hoher Entladungsstrom auftritt. Ein solcher in den deformierbaren Abschnitten 23 und 24 gegensinnig fließender Entlade- oder Fehlerstrom führt zu einer Abstoßungskraft zwischen den deformierbaren Abschnitten 23 und 24.

In Figur 3 ist das Elektronikmodul in einem Zustand dargestellt, in dem sich aufgrund eines defekten Bauteils der Kondensator 12 entladen hat und einen Entladestrom erzeugt hat, welcher zu der oben beschriebenen Verformung führt. Aufgrund der Verformung kontaktiert der Abschnitt 24 das Kontaktteil 20 und bildet so eine Verbindung zwischen den Anschlussklemmen 16,17. Diese Verbindung der Anschlussklemmen 16,17 ist so geschaltet, dass damit das defekte Elektronikmodul überbrückt ist.

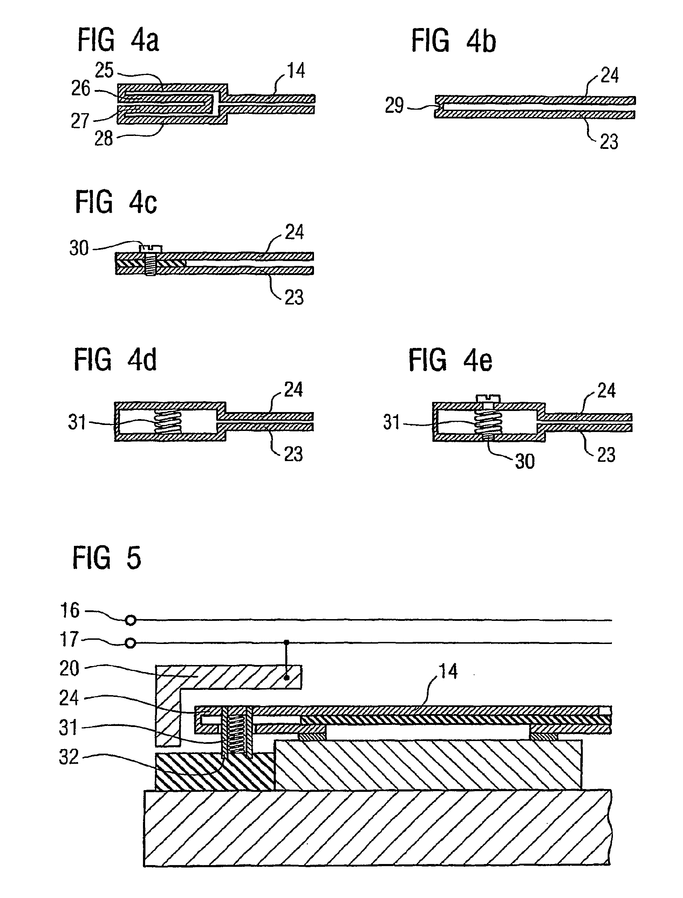

Figur 4a zeigt eine weitere Ausgestaltungsmöglichkeit des Verbindungsleiters 14, bei dem anstatt der U-förmigen Schleife mit zwei parallelen deformierbaren Abschnitten gemäß Figur 2 eine schleifenförmige Anordnung mit vier parallel zueinander angeordneten deformierbaren Abschnitten oder Leiterstücken 25,26,27,28 ausgebildet ist. Eine solche Anordnung verstärkt dem oben beschriebenen Verformungseffekt der Anordnung, da ein gegensinniger Strom in mehreren Paaren der Leiterstücke 25 und 26 bzw. 26 und 27 bzw. 27 und 28 fließt, so dass aufgrund elektromagnetischer Effekte eine abstoßende Kraft zwischen den jeweiligen Leiterstücken verstärkt ist.

In Figur 4b ist eine weitere Möglichkeit dargestellt, die U-förmige Schleifenanordnung des Verbindungsleiters 13 mit zwei parallelen Abschnitten 23 und 24 auszubilden. Die gebogene Verbindung 29 der deformierbaren Abschnitte 23 und 24 ist bei diesem Ausführungsbeispiel mit einer geringeren Querschnittsfläche als die Querschnittsfläche der Abschnitte 23 und 24 ausgebildet. Dadurch wird eine Sollbruchstelle an der Verbindung 29 definiert, so dass bei der durch den Fehlerstrom erzeugten Kraft die Verbindung der Abschnitte 23 und 24 an der Sollbruchstelle 29 aufbricht. Der Abschnitt 24 wird wie bereits in Zusammenhang mit Figur 3 beschrieben, gegen das Kontaktteil 20 gedrückt und bildet einen Kurzschluss zwischen den Anschlussklemmen 16 und 17 aus.

In Figur 4c dargestellt ist eine andere Ausführungsform der Erfindung. In diesem Ausführungsbeispiel findet die Verbindung der Abschnitte 23 und 24 über eine Schraube 30 statt, wobei die bei einem Fehlerstrom erzeugte Kraft zu einem Abscheren des Gewindes der Kunststoffschraube 30 führt, so dass die Verbindung zwischen den Abschnitten 23 und 24 unterbrochen wird und der Abschnitt 24 gegen das Kontaktteil 20 gedrückt wird und ebenfalls eine Verbindung zwischen den Anschlussklemmen 16 und 17 ausbildet.

In Figur 4d ist ein weiteres Ausführungsbeispiel dargestellt, bei dem die U-förmige Schleifenanordnung der Abschnitte 23 und 24 eine zusätzliche Vorspannung über ein Federelement 31 erfährt. Durch das Federelement 31 wird eine zusätzliche Kraft auf den deformierbaren Abschnitt 24 ausgeübt, so dass die durch den Abschnitt 24 erzeugte leitende Verbindung zwischen den Anschlussklemmen 16 und 17 durch die zusätzliche Kraft des Federelementes 31 verbessert wird.

In Figur 4e ist eine Kombination einer Schraube 30 mit einem Federelement 31 zur Verbindung der Abschnitte 23 und 24 dargestellt.

Figur 5 zeigt ein anderes Ausführungsbeispiel für eine Kombination eines Federelements 31 mit einem Hilfselement 32, welches mit der Isolierung verschraubt ist und die Federkraft des Federelements 31 aufnimmt. Bei einem Fehlerstrom wird durch die elektrodynamische Kraft die Verschraubung des Hilfselements 32 abgeschert, so dass die Federkraft des Federelementes 31 den deformierbaren Abschnitt 24 gegen das Kontaktteil 20 drückt und die Verbindung zwischen den Anschlussklemmen 16 und 17 ausbildet.

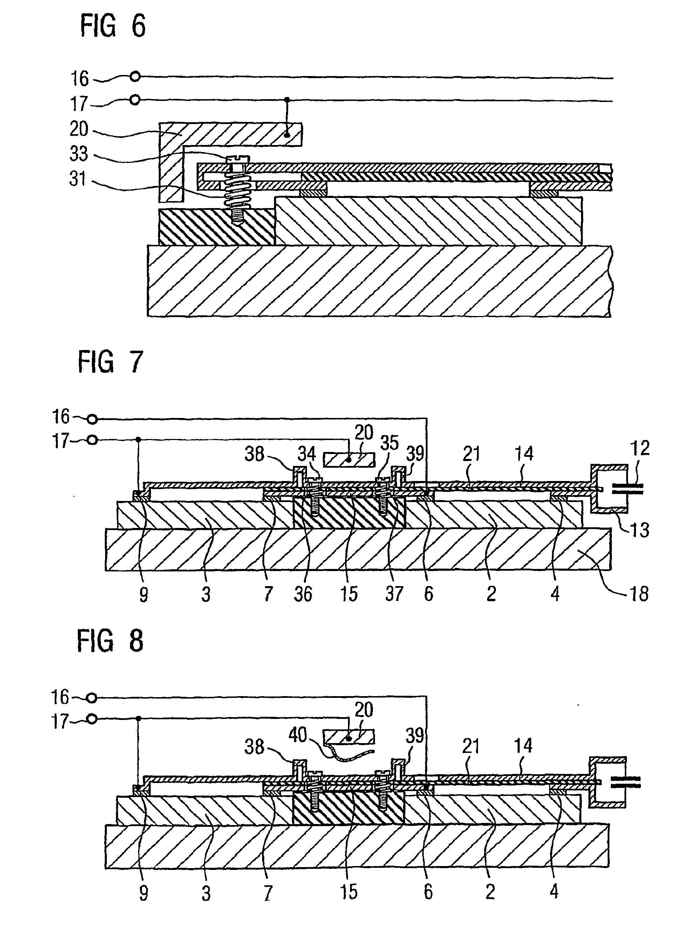

Figur 6 zeigt eine zweckmäßige Ausgestaltung des Ausführungsbeispiels aus Figur 5, bei dem das Hilfselement 32 durch eine Schraube 33 ausgebildet ist.

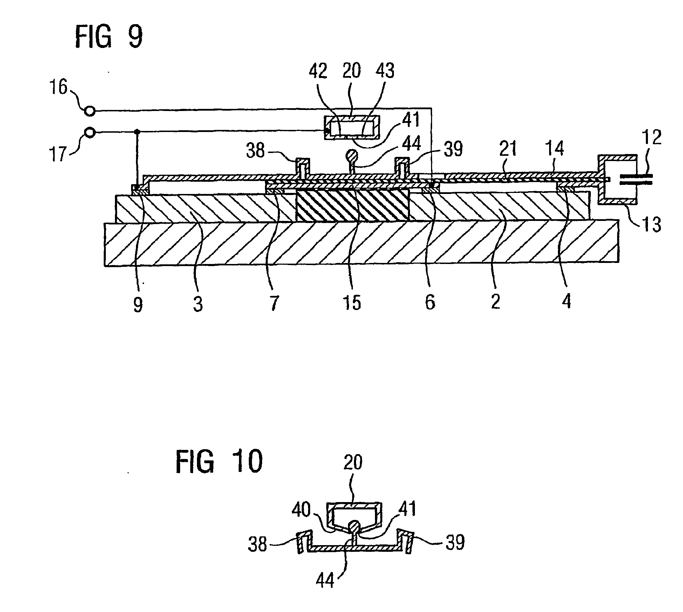

In Figur 7 ist eine andere Ausgestaltung des erfindungsgemäßen Elektronikmoduls dargestellt, bei dem das Kontaktteil 20 so angeordnet ist, dass bei einem Fehlerstrom, der in den Verbindungsleitern 14 und 15 gegensinnig fließt und dadurch zu einer abstoßenden Kraft zwischen diesen führt, der Verbindungsleiter 14 deformiert und gegen das Kontaktteil 20 gedrückt wird. Dabei ist die Isolierung 21 nicht mit den Verbindungsleitern 14 und 15 verklebt, sondern über Schrauben 34 und 35 befestigt. Federelemente 36,37 sind an den Schrauben angeordnet, die im Fehlerfall die Verformung des Verbindungsleiters 14 durch die abstoßende Kraft verstärken. Den Federelementen benachbart weist der Verbindungsleiter 14 in der gezeigten Seitenansicht nach oben weisende Leiterschleifen 38, 39 auf, die für die Deformation des Verbindungsleiters 14 in Richtung des Kontaktteils vorgesehen sind, deren Wirkung mit Bezug auf die Figur 10 beschrieben wird. Der Verbindungsleiter 14 wird im Fehlerfall durch die elektrodynamische und die Federkraft gegen das Kontaktteil 20 gedrückt, wodurch die Verbindung zwischen den Anschlussklemmen 16 und 17 ausgebildet wird.

Figur 8 zeigt eine andere Ausführungsform des erfindungsgemäßen Elektronikmoduls aus Figur 7, bei dem am Kontaktteil 20 ein Federelement 40 angeordnet ist, so dass der im Kurzschlussfall durch die elektromagnetische Kraft deformierte Verbindungsleiter 14 gegen das Federelement 40 gedrückt wird und eine sichere Verbindung zwischen den Anschlussklemmen 16 und 17 ausbildet.

Figur 9 zeigt eine andere Ausführungsform der Verbindung zwischen dem deformierbaren Verbindungsleiter 14 und dem Kontaktteil 20. Das Kontaktteil 20 weist eine Aussparung 41 sowie elastische Teile 42 und 43 auf. Am Verbindungsleiter 14 ist ein Formstück 44 angeordnet. Bei der im Kurzschlussfall zwischen den Verbindungsleitern 14 und 15 auftretenden elektromagnetischen Kraft wird das Formstück 44 nach oben in Richtung des Kontaktteils 20 bewegt, wobei durch die ausreichend große Kraft das Formstück die elastischen Teile 42 und 43 nach oben deformiert und durch die Aussparung 41 hindurch mit den elastischen Teilen 42 und 43 einrastet, so dass eine Verbindung zwischen den Anschlussklemmen 16 und 17 ausgebildet ist.

Figur 10 zeigt die formschlüssige Verbindung des Formstücks 44 mit dem Kontaktteil 20 in einer eingerasteten Position, nachdem der Kurzschlussstrom im Elektronikmodul geflossen ist. Der Verbindungsleiter 14 ist durch die elektrodynamische Kraft deformiert, wobei die Leiterschleifen 38, 39 jeweils in vom Formstück 44 hinweg weisende Richtung gebogen sind, so dass sich der Verbindungsleiter 14 nach oben deformiert und das Formstück 44 durch die Aussparung 41 mit den elastischen 42 und 43 einrastet und eine formschlüssige Verbindung zwischen dem Formstück 44 und dem Kontaktteil 20 ausbildet. Im Rahmen der Erfindung sind auch andere Einrastmechanismen zum Ausbilden einer formschlüssigen Verbindung realisierbar.

### Bezugszeichenliste

- 1: Elektronikmodul
- 2,3: IGBT
- 4: Emitteranschluss
- 5: Gateanschluss
- 6: Kollektoranschluss
- 7: Emitteranschluss
- 8: Gateanschluss
- 9: Kollektoranschluss
- 10,11: Freilaufdioden
- 12: Kondensator
- 13,14,15: Verbindungsleiter
- 16,17: Anschlussklemmen
- 18: Kühlkörper
- 19: Isolationskörper
- 20: Kontaktteil
- 21: Isolierung
- 22: Aussparung
- 23,24: Abschnitte
- 25,26,27,28: Leiterabschnitte
- 29: Verbindung
- 30: Kunststoffschraube
- 31: Federelement
- 32: Hilfselement
- 33: Kunststoffschraube
- 34,35: Schrauben
- 36,37: Federelemente
- 38, 39: Leiterschleifen
- 40: Federelement
- 41: Aussparung
- 42,43: Elastische Teile
- 44: Formstück

## Patentansprüche

1. Elektronikmodul (1) mit mindestens einer ersten und einer zweiten Anschlussklemme (16,17) sowie mit über Verbindungsleiter (13,14,15) verbundenen Leistungshalbleitern (2,3), den Leistungshalbleitern (2,3) jeweils parallel geschalteten Dioden (10,11) und wenigstens einem ebenfalls über Verbindungsleiter (13,14,15) mit den Leistungshalbleitern (2,3) verbundenen Kondensator (12),
**dadurch gekennzeichnet, dass**
die Verbindungsleiter (13,14,15) mindestens zwei parallel zueinander verlaufende Abschnitte aufweisen, von denen mindestens einer deformierbar ist, über die der im Elektronikmodul (1) fließende Strom gegensinnig geführt ist, so dass aufgrund elektromagnetischer Wechselwirkung eine Kraft erzeugt wird, welche die Verbindungsleiter auseinanderdrückt, und die so dimensioniert sind, dass sie beim Überschreiten eines Schwellstromes eine leitende Verbindung zwischen den Anschlussklemmen (16,17) ausbilden und die Leistungshalbleiter und jeden Kondensator überbrücken.

2. Elektronikmodul (1) nach Anspruch 1,
**dadurch gekennzeichnet, dass**
die deformierbaren Abschnitte durch Stromschienen (23,24,25,26,27,28) realisiert sind, die mit der ersten Anschlussklemme (16) unmittelbar verbunden sind, wobei die Stromschienen in der Nähe eines Kontaktteils (20) angeordnet sind, welches mit der zweiten Anschlussklemme (17) unmittelbar verbunden ist.

3. Elektronikmodul nach Anspruch 2,
**dadurch gekennzeichnet, dass**
die Stromschienen (23,24,25,26,27,28) als mäanderförmig gebogene Stromschiene realisiert sind.

4. Elektronikmodul nach Anspruch 3,
**dadurch gekennzeichnet, dass**
gebogene Bereiche (29) der Stromschiene (23,24,25,26,27,28) eine geringere Querschnittsfläche als die geradlinigen Bereiche (23,24,25,26,27,28) aufweisen.

5. Elektronikmodul nach Anspruch 2 bis 4,
**dadurch gekennzeichnet, dass**
Mittel (30,31,32,33,34,35,36,37,38,39,40) zum Ausbilden einer kraftschlüssigen Verbindung eines der deformierbaren Abschnitte mit dem Kontaktteil (20) vorgesehen sind.

6. Elektronikmodul nach Anspruch 5,
**dadurch gekennzeichnet, dass**
die Mittel (30,31,32,33,34,35,36,37,38,39,40) eine Schraubverbindung (34,35) umfassen.

7. Elektronikmodul nach Anspruch 5,
**dadurch gekennzeichnet, dass**
die Mittel (30,31,32,33,34,35,36,37,38,39,40) mindestens ein Federelement (31,36,37,38) umfassen.

8. Elektronikmodul nach Anspruch 7,
**dadurch gekennzeichnet, dass**
das Federelement (31,36,37) zwischen den deformierbaren Abschnitten angeordnet ist.

9. Elektronikmodul nach Anspruch 7,
**dadurch gekennzeichnet, dass**
das Federelement (40) am Kontaktteil (20) angeordnet ist.

10. Elektronikmodul nach Anspruch 2 bis 9,
**dadurch gekennzeichnet, dass**
Mittel (38,39,40,41,42,43,44) zum Ausbilden einer formschlüssigen Verbindung der deformierbaren Abschnitte mit dem Kontaktteil (20) vorgesehen sind.

## Claims

1. Electronic module (1) having at least one first and one second connection terminal (16, 17) as well as power semiconductors (2, 3) which are connected by means of connecting conductors (13, 14, 15), diodes (10, 11) which are respectively connected in parallel with the power semiconductors (2, 3) and at least one capacitor (12) which is likewise connected to the power semiconductors (2, 3) by means of connecting conductors (13, 14, 15),
**characterized in that**
the connecting conductors (13, 14, 15) have at least two sections which run parallel to one another and at least one of which can be deformed, the current flowing in the electronic module (1) being guided in opposite directions in said sections, with the result that a force which pushes the connecting conductors apart is produced on account of electromagnetic interaction, and said sections being dimensioned in such a manner that they form a conductive connection between the connection terminals (16, 17) when a threshold current is exceeded and bridge the power semiconductors and each capacitor.

2. Electronic module (1) according to Claim 1,
**characterized in that**
the deformable sections are realized using busbars (23, 24, 25, 26, 27, 28) which are directly connected to the first connection terminal (16), the busbars being arranged in the vicinity of a contact part (20) which is directly connected to the second connection terminal (17).

3. Electronic module according to Claim 2,
**characterized in that**
the busbars (23, 24, 25, 26, 27, 28) are realized in the form of a busbar which is curved in meandering fashion.

4. Electronic module according to Claim 3,
**characterized in that**
curved regions (29) of the busbar (23, 24, 25, 26, 27, 28) have a smaller cross-sectional area than the straight regions (23, 24, 25, 26, 27, 28).

5. Electronic module according to Claims 2 to 4,
**characterized in that**
means (30, 31, 32, 33, 34, 35, 36, 37, 38, 39, 40) are provided for the purpose of forming a force-fitting connection between one of the deformable sections and the contact part (20) .

6. Electronic module according to Claim 5,
**characterized in that**
the means (30, 31, 32, 33, 34, 35, 36, 37, 38, 39, 40) comprise a screw connection (34, 35).

7. Electronic module according to Claim 5,
**characterized in that**
the means (30, 31, 32, 33, 34, 35, 36, 37, 38, 39, 40) comprise at least one spring element (31, 36, 37, 38).

8. Electronic module according to Claim 7,
**characterized in that**
the spring element (31, 36, 37) is arranged between the deformable sections.

9. Electronic module according to Claim 7,
**characterized in that**
the spring element (40) is arranged on the contact part (20).

10. Electronic module according to Claims 2 to 9,
**characterized in that**
means (38, 39, 40, 41, 42, 43, 44) are provided for the purpose of forming a form-fitting connection between the deformable sections and the contact part (20).

## Revendications

1. Module ( 1 ) électronique ayant au moins une première et une deuxième borne ( 16, 17 ) de connexion, ainsi que des semi-conducteurs ( 2, 3 ) de puissance reliés par des conducteurs ( 13, 14, 15 ) de liaison, des diodes ( 10, 11 ) montées respectivement en parallèle aux semi-conducteurs (2, 3 ) de puissance et au moins un condensateur ( 12 ) relié aux semi-conducteurs ( 2, 3 ) de puissance également par des conducteurs ( 13, 14, 15 ) de liaison,
**caractérisé en ce que** les conducteurs ( 13, 14, 15 ) de liaison ont au moins deux parties s'étendant parallèlement l'une à l'autre, dont au moins l'une est déformable, par lesquelles le courant passant dans le module ( 1 ) électronique passe en sens contraire, de sorte qu'en raison de l'interaction électromagnétique il se produit une force qui repousse les uns des autres les conducteurs de liaison, et qui sont dimensionnés de sorte que, lorsqu'un courant de seuil est dépassé, une liaison conductrice se forme entre les bornes ( 16, 17 ) de connexion et shunte les semi-conducteurs de puissance et chaque condensateur.

2. Module ( 1 ) électronique suivant la revendication 1,
**caractérisé en ce que** les parties déformables sont réalisées par des barres ( 23, 24, 25, 26, 27, 28 ) de courant, qui sont reliées directement à la première borne ( 16 ) de connexion, les barres de courant étant disposées près d'une pièce ( 20 ) de contact qui est reliée directement à la deuxième borne (17) de connexion.

3. Module ( 1 ) électronique suivant la revendication 2,
**caractérisé en ce que** les barres ( 23, 24, 25, 26, 27, 28 ) de courant sont réalisées sous la forme de barres de courant sinueuses.

4. Module ( 1 ) électronique suivant la revendication 3,
**caractérisé en ce que** des parties ( 29 ) courbées des barres ( 23, 24, 25, 26, 27, 28 ) de courant ont une surface de section transversale plus petite que les parties ( 23, 24, 25, 26, 27, 28 ) rectilignes.

5. Module ( 1 ) électronique suivant les revendications 2 à 4,
**caractérisé en ce qu'**il est prévu des moyens ( 30, 31, 32, 33, 34, 35, 36, 37, 38, 39, 40 ) de formation d'une liaison à coopération de force de l'une des parties déformables à la pièce ( 20 ) de contact.

6. Module ( 1 ) électronique suivant la revendication 5,
**caractérisé en ce que** les moyens ( 30, 31, 32, 33, 34, 35, 36, 37, 38, 39, 40 ) comprennent un vissage ( 34, 35 ).

7. Module ( 1 ) électronique suivant la revendication 5,
**caractérisé en ce que** les moyens ( 30, 31, 32, 33, 34, 35, 36, 37, 38, 39, 40 ) comprennent au moins un élément ( 31, 36, 37, 38 ) à ressort.

8. Module ( 1 ) électronique suivant la revendication 7,
**caractérisé en ce que** l'élément ( 31, 36, 37 ) à ressort est disposé entre les parties déformables.

9. Module ( 1 ) électronique suivant la revendication 7,
**caractérisé en ce que** l'élément ( 40 ) à ressort est disposé sur la pièce ( 20 ) de contact.

10. Module ( 1 ) électronique suivant les revendications 2 à 9,
**caractérisé en ce qu'**il est prévu des moyens ( 38, 39, 40, 41, 42, 43, 44 ) de formation d'une liaison à complémentarité de forme des parties déformables à la pièce ( 20 ) de contact.
